# EUROPÄISCHE PATENTSCHRIFT

(11) **EP 3 696 927 B1**
(45) Veröffentlichungstag und Bekanntmachung des Hinweises auf die Patenterteilung: **12.08.2026**
(21) Anmeldenummer: 19157428.4
(22) Anmeldetag: 15.02.2019
(51) Int. Cl.: H02H 3/08, H02H 3/087, H02H 3/30, H02H 7/26, G01R 19/25, G01R 31/327, H02J 1/08, H02J 13/00, H02J 13/12, H02H 1/00, H02H 3/04

(54) **VORRICHTUNG UND VERFAHREN ZUR ÜBERWACHUNG MEHRERER STROMABGÄNGE IN EINEM STROMNETZ**
DEVICE AND METHOD FOR MONITORING A PLURALITY OF FEEDERS IN A POWER GRID
DISPOSITIF ET PROCÉDÉ DE SURVEILLANCE D'UNE PLURALITÉ DE DÉPARTS DE COURANT DANS UN RÉSEAU ÉLECTRIQUE

(43) Veröffentlichungstag der Anmeldung: 19.08.2020
(73) Patentinhaber: Siemens Aktiengesellschaft, 80333 München (DE)
(72) Erfinder: Schierling, Hubert, 91052 Erlangen (DE)
(74) Vertreter: Siemens Patent Attorneys

(56) Entgegenhaltungen:
- EP-A1- 0 096 601
- EP-A1- 0 209 765
- WO-A2-2005/006363
- DE-A1- 102016 123 860

## Beschreibung

Die Erfindung betrifft eine Funktionsüberwachung in einem Abzweigelement, welches in einem Stromnetz zur Versorgung zumindest eines Verbrauchers mit elektrischer Energie bestimmt ist, und insoweit ein Abzweigelement und ein Verfahren zur automatischen Überwachung eines ersten Stromabgangs sowie zumindest eines weiteren Stromabgangs im Anschluss an ein Abzweigelement in einem Stromnetz.

Als Abzweigelement wird hier und im Folgenden ein Schalt- und Schutzelement bezeichnet, nämlich ein Schalt- und Schutzelement, welches einem an ein Stromnetz, insbesondere ein Gleichstromnetz, angeschlossenen Verbraucher oder einem Netzzweig/ Lastbereich mit mehreren Verbrauchern vorgeschaltet ist. Ein solches Abzweigelement umfasst zumindest ein elektrisch schaltbares Schaltelement und trennt in einem Fehlerfall den oder jeden angeschlossenen Verbraucher - oder allgemein einen Lastbereich - von der Speiseseite. Dies ist die Schutzfunktion des Abzweigelements. Genauso kann mittels des Abzweigelements auch durch einen auf das Schaltelement wirkenden Schaltbefehl ein Abschalten des von dem Abzweigelement ausgehenden Lastbereichs und damit das Abschalten des oder jedes an das Abzweigelement angeschlossenen Verbrauchers bewirkt werden. Dies ist die Schaltfunktion des Abzweigelements.

Zum Abschalten eines Lastbereichs in einem Fehlerfall misst das Abzweigelement bisher nur den Summenstrom aller angeschlossenen Verbraucher. Damit schützt das Abzweigelement grundsätzlich im Falle eines ausgangsseitigen Kurzschlusses. Eine spezifische Überwachung und ein spezifischer Schutz einzelner Verbraucher ist bisher nicht vorgesehen. Ein solcher Schutz wird bisher zum Beispiel einzeln oder kumulativ mit zusätzlichen Sicherungen, Verbrauchern mit eigener Strombegrenzung oder vergleichsweise großen Leiterquerschnitten versucht. Zusätzliche Sicherungsmaßnahmen sind dabei zusätzliche Sicherungen im jeweiligen Verbraucher oder im Strompfad zu dem jeweiligen Verbraucher. Ein Beispiel für einen Verbraucher mit einer eigenen Strombegrenzung ist ein Antrieb mit einem Wechselrichter mit interner Stromregelung. Vergleichsweise große Leiterquerschnitte sind Querschnitte von Leitungen zu den einzelnen Verbrauchern, welche auf einen auf den maximal über das Abzweigelement fließenden Strom abgestimmt sind. Jede dieser konventionellen Maßnahmen und mehr noch eine Kombination mehrerer Maßnahmen führt zu einem zusätzlichen Bauteil-, Schaltungs- und/oder Materialaufwand auf der Ausgangsseite eines Abzweigelements. Bei einem Stromnetz mit einer Vielzahl von Abzweigelementen gilt dies für jedes einzelne Abzweigelement und dessen Ausgangsseite.

EP0096601A1 (Merlin Gerin) 21. Dezember 1983 beschreibt eine elektrische Energieverteilungsanlage mit mehreren Ausgängen (30; 217), die von einer gemeinsamen Eingangsspeisung versorgt werden, wobei jeder Ausgang von einem Teilgerät (24; D1-Dn) zur Ausgangsstrom-Unterbrechung geschützt wird, und wobei die gemeinsame Eingangsspeisung ein allgemeines Schutzgerät (44; 44, 52; DG) aufweist mit einer Schutzvorrichtung (46; 222) gegen Kurzschlüsse.

DE102016123860A1 (Phoenix Contact GmbH & Co) 14. Juni 2018 beschreibt in Fig. 4 eine Schutzanordnung (20) für mehrere Ausgänge (A1 , A2 , A3 , AN). Dabei wird ein Eingangsstrom an einem Knotenpunkt (KP) auf mehrere Stromversorgungspfade aufgeteilt. In jedem Stromversorgungspfad ist dabei ein Pfadschutzschalter (S1 , S2 , S3 , SN) angeordnet. Aus Sicherheitsgründen ist in einem Eingangsstrompfad zwischen einem Eingang (E) und dem Knotenpunkt (KP) ein weiterer Pfadschutzschalter (S0) als Hauptschutzschalter angeordnet.

Eine Aufgabe der vorliegenden Erfindung besteht ausgehend davon darin, eine Vorrichtung zur automatischen Überwachung mehrerer Stromabgänge, nämlich eines ersten Stromabgangs sowie zumindest eines weiteren Stromabgangs, im Anschluss an ein zumindest ein elektrisch schaltbares Schaltelement umfassendes Abzweigelement anzugeben, welche auch eine spezifische Überwachung und einen spezifischen Schutz einzelner Verbraucher ermöglicht. Eine Aufgabe der Erfindung besteht weiterhin darin, ein Verfahren für eine solche automatische Überwachung anzugeben.

Diese Aufgabe wird mittels eines Abzweigelements mit einer zur automatischen Überwachung eines ersten Stromabgangs sowie zumindest eines weiteren Stromabgangs im Anschluss an das Abzweigelement der eingangs genannten Art bestimmten Vorrichtung (Überwachungsvorrichtung) mit den Merkmalen des Anspruchs 1 und mittels eines Verfahrens (Überwachungsverfahren) mit den Merkmalen des parallelen Verfahrensanspruchs gelöst.

Das Abzweigelement umfasst ein elektrisch schaltbares Schaltelement. Das Abzweigelement umfasst als Schaltelement zum Beispiel einen elektrisch schaltbaren Halbleiterschalter, insbesondere einen elektrisch schaltbaren Leistungshalbleiterschalter. Ein Schaltzustand des Schaltelements ist über einen Ansteuereingang des Schaltelements und mittels eines von einer Ansteuereinheit generierbaren und auf den Ansteuereingang ausgegebenen Ansteuersignals beeinflussbar und wird beim Betrieb des Abzweigelements mittels eines von der Ansteuereinheit generierten und auf den Ansteuereingang ausgegebenen Ansteuersignals beeinflusst; das Schaltelement wird mittels des Ansteuersignals in einen geöffneten oder geschlossenen Zustand geschaltet.

Zum Anschluss an ein speisendes Stromnetz, insbesondere ein Gleichstromnetz, weist das Abzweigelement einen Stromzugang auf. Zum Anschluss zumindest zweier Verbraucher (erster Verbraucher, zweiter Verbraucher) an das Abzweigelement und damit an das speisende Stromnetz ist dem Abzweigelement ein erster Stromabgang zum Anschluss des ersten Verbrauchers und zumindest ein weiterer Stromabgang zum Anschluss des zweiten Verbrauchers zugeordnet. Je nach Ausführungsform umfasst das Abzweigelement jeden Stromabgang selbst oder jeder Stromabgang ist einer vom Abzweigelement baulich getrennten, aber mit dem Abzweigelement elektrisch verbundenen Einheit zugeordnet. Dem ersten Stromabgang ist eine erste Strommesseinrichtung zugeordnet und dem weiteren Stromabgang ist eine weitere Strommesseinrichtung oder jedem weiteren Stromabgang ist jeweils eine weitere Strommesseinrichtung zugeordnet, zum Beispiel indem ein Stromwandler oder dergleichen in den Stromabgang geschaltet oder an den Stromabgang angeschlossen ist. Mittels der ersten Strommesseinrichtung sowie der oder jeder weiteren Strommesseinrichtung ist jeweils ein Messwert, insbesondere ein Strommesswert, erfassbar und wird beim Betrieb des Abzweigelements jeweils ein Messwert, insbesondere ein Strommesswert, erfasst. Jeder Strommesswert wird entweder direkt oder in Form einer aus dem Strommesswert abgeleiteten Größe weiter verarbeitet. Beispiele für eine aus einem Strommesswert abgeleitete Größe sind ein Effektivwert, ein I²t-Wert oder dergleichen.

Die Überwachungsvorrichtung ist dafür bestimmt und eingerichtet, einerseits einen Vergleich einer Summe der erfassten Strommesswerte mit einem vorgegebenen oder vorgebbaren Schwellwert durchzuführen und in Abhängigkeit vom Ergebnis des Vergleichs das Schaltelement des Abzweigelements anzusteuern sowie andererseits einen Vergleich jedes einzelnen erfassten Strommesswerts oder eines daraus abgeleiteten Effektiv- oder I²t-Werts mit einem vorgegebenen oder vorgebbaren Grenzwert durchzuführen und in Abhängigkeit vom Ergebnis jedes Vergleichs das Schaltelement des Abzweigelements anzusteuern.

Optional ist auch eine gleichzeitige oder quasi-gleichzeitige Überwachung mehrerer Werte möglich, zum Beispiel eine Überwachung eines Strommesswerts (Augenblickswert des Stroms) zur Kurzschlussüberwachung und eine Überwachung eines abgeleiteten Stromwerts, zum Beispiel des I²t-Werts, für einen Leitungsschutz (Überlastschutz). Die optionale gleichzeitige oder quasi-gleichzeitige Überwachung mehrerer Werte umfasst auch die Überwachung mehrerer aus einem Strommesswert abgeleiteter Stromwerte, zum Beispiel Effektivwert, I²t-Wert und dergleichen. Weitere Beispiele für aus einem Strommesswert ableitbare oder abgeleitete Stromwerte sind ein Frequenzspektrum, ein Abschnitt eines Frequenzspektrums (Frequenzbereich) oder eine Amplitude einer einzelnen Spektrallinie. Dadurch lässt sich erkennen und verhindern, dass durch die Schaltfrequenz eines Verbrauchers Resonanzen im Netz angeregt werden, die zu einer Überlastung von Kondensatoren führen könnten. Auch Erdschlüsse auf dem Motorkabel führen zu schaltfrequenten Strömen, so dass auch eine Erdschlussüberwachung möglich ist.

Bezüglich des Verfahrens zur automatischen Überwachung eines ersten Stromabgangs sowie zumindest eines weiteren Stromabgangs im Anschluss an ein Abzweigelement in einem Stromnetz ist vorgesehen, dass mittels der ersten Strommesseinrichtung sowie der oder jeder weiteren Strommesseinrichtung jeweils ein Strommesswert erfasst wird, dass einerseits eine Summe der erfassten Strommesswerte mit einem vorgegebenen oder vorgebbaren Schwellwert verglichen und in Abhängigkeit vom Ergebnis des Vergleichs das Schaltelement des Abzweigelements angesteuert wird und andererseits jeder einzelne erfasste Strommesswert oder ein daraus abgeleiteter Effektiv- oder I²t-Werts mit einem vorgegebenen oder vorgebbaren Grenzwert verglichen und in Abhängigkeit vom Ergebnis jedes Vergleichs das Schaltelement des Abzweigelements angesteuert wird.

Der Schwellwert und/oder der Grenzwert liegen zum Beispiel in einem Speicher vor, insbesondere in einem von dem Abzweigelement umfassten Speicher. Dort liegt der Schwellwert und/oder der Grenzwert zum Beispiel in einer dem Speicher fest eingeprägten Form oder in einer zum Beispiel im Wege einer Parametrierung veränderbaren Form vor.

Das Verfahren wird bevorzugt mittels einer Überwachungsvorrichtung wie hier und im Folgenden beschrieben ausgeführt. Bei einem solchen mittels der Überwachungsvorrichtung ausgeführten Verfahren wird mittels der Überwachungsvorrichtung einerseits die Summe der jeweils erfassten Strommesswerte mit einem vorgegebenen oder vorgebbaren Schwellwert verglichen und in Abhängigkeit vom Ergebnis des Vergleichs das Schaltelement des Abzweigelements angesteuert und andererseits jeder einzelne jeweils erfasste Strommesswert oder ein daraus abgeleiteter Effektiv- oder I²t-Werts mit einem vorgegebenen oder vorgebbaren Grenzwert verglichen und in Abhängigkeit vom Ergebnis jedes Vergleichs das Schaltelement des Abzweigelements angesteuert.

Die Überwachungsvorrichtung wirkt mit dem zu überwachenden Abzweigelement zusammen und ist Bestandteil des Abzweigelements, zum Beispiel indem die Überwachungsvorrichtung mit der Ansteuereinheit des Abzweigelements kombiniert ist.

Insoweit ist die Erfindung ein Abzweigelement mit einer Überwachungsvorrichtung wie hier und im Folgenden beschrieben und die eingangs genannte Aufgabe wird mit einem solchen Abzweigelement gelöst. Bei einem Abzweigelement, welches die Überwachungsvorrichtung umfasst, ist die Erfindung auch ein Verfahren zum Betrieb des Abzweigelements, wobei mittels der Überwachungsvorrichtung die oben beschriebene automatische Überwachung eines ersten Stromabgangs sowie zumindest eines weiteren Stromabgangs im Anschluss an das jeweilige Abzweigelement durchgeführt wird. Damit ist eine Überwachung der an das Abzweigelement anschließenden Stromabgänge und des oder jedes daran angeschlossenen Verbrauchers realisiert und eine eventuell notwendige Abschaltung der Stromabgänge erfolgt mittels genau eines Schaltelements, nämlich mittels des Schaltelements des Abzweigelements.

Ein wesentlicher Vorteil der Erfindung besteht darin, dass durch die Überwachung jedes einzelnen Stromabgangs im Anschluss an das Abzweigelement, nämlich durch den Vergleich jedes einzelnen dort aufgenommenen Strommesswerts oder eines daraus abgeleiteten Stromwerts mit einem Grenzwert, jeder an einen Stromabgang des Abzweigelements angeschlossene Verbraucher spezifisch überwacht und geschützt werden kann. Jeder überwachte Strommesswert/Stromwert ist ein Maß für den zu genau einem Verbraucher fließenden Strom. Bei einer Grenzwertüberschreitung ist eine Überstromsituation erkannt. Zum Schutz des Verbrauchers wird das Schaltelement des Abzweigelements geöffnet. Damit sind dieser Verbraucher und alle anderen an das Abzweigelement angeschlossenen Verbraucher vom Netz getrennt. Eine ansonsten drohende Beschädigung oder gar Zerstörung desjenigen Verbrauchers, bei dem die Überstromsituation eingetreten ist, wird vermieden. Durch die Abschaltung aller angeschlossenen Verbraucher kann anschließend eine Fehlersuche durchgeführt werden.

Ein weiterer wesentlicher Vorteil der Erfindung besteht darin, dass die Schutzfunktion für mehrere Stromabgänge und den oder die daran angeschlossenen Verbraucher mit nur einem Schaltelement, nämlich dem Schaltelement des den Stromabgängen vorgeschalteten Abzweigelements, realisiert ist.

Ein nochmals weiterer Vorteil der Erfindung besteht darin, dass eine Notwendigkeit zusätzlicher Sicherungen oder sonstiger Maßnahmen zur Strombegrenzung in den einzelnen Verbrauchern vermieden wird.

Vorteilhafte Ausgestaltungen der Erfindung sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Sie sind nicht als ein Verzicht auf die Erzielung eines selbständigen, gegenständlichen Schutzes für die Merkmale oder Merkmalskombinationen eines abhängigen Anspruchs zu verstehen. Des Weiteren ist im Hinblick auf eine Auslegung der Ansprüche sowie der Beschreibung bei einer näheren Konkretisierung eines Merkmals in einem abhängigen Anspruch davon auszugehen, dass eine derartige Beschränkung in den jeweils vorangehenden Ansprüchen sowie einer allgemeineren Ausführungsform der gegenständlichen Überwachungsvorrichtung / des gegenständlichen Überwachungsverfahrens nicht vorhanden ist. Jede Bezugnahme in der Beschreibung auf Aspekte abhängiger Ansprüche ist demnach auch ohne speziellen Hinweis ausdrücklich als Beschreibung optionaler Merkmale zu lesen. Schließlich ist darauf hinzuweisen, dass das hier angegebene Verfahren auch entsprechend der abhängigen Vorrichtungsansprüche weitergebildet sein kann und umgekehrt. Dementsprechend kann das Überwachungsverfahren auch mittels einzelner oder mehrerer Verfahrensmerkmale fortgebildet sein, die sich auf von der Überwachungsvorrichtung ausgeführte Verfahrensschritte beziehen, und die Überwachungsvorrichtung kann genauso durch Mittel zur Ausführung von im Rahmen des Überwachungsverfahrens ausgeführten Verfahrensschritten fortgebildet sein.

Bei einer vorteilhaften Ausführungsform des Abzweigelements oder des Überwachungsverfahrens ist für den ersten Stromabgang und den oder jeden weiteren Stromabgang jeweils ein eigener Grenzwert vorgegeben oder vorgebbar. Dann können an die Stromabgänge Verbraucher mit unterschiedlichem Leistungsbedarf angeschlossen werden und für jeden Verbraucher ist der bei dessen Speisung fließende Strom einzeln überwachbar und wird beim Betrieb des Abzweigelements im Rahmen des Überwachungsverfahrens einzeln überwacht. Dies macht die Verwendung passender Leitungsquerschnitte, also Leitungsquerschnitte, welche auf einen jeweiligen Leistungsbedarf der angeschlossenen Verbraucher abgestimmt sind, möglich. Eine Verwendung unnötig großer Leitungsquerschnitte wird damit vermieden.

Bei einer vorteilhaften Ausführungsform eines Abzweigelements mit einer Überwachungsvorrichtung wie hier und im Folgenden beschrieben umfasst das Abzweigelement die Strommesseinrichtung und die oder jede weitere Strommesseinrichtung. Es ergibt sich damit ein kompaktes und unkompliziert verwendbares Gerät. Alle Signalpfade von der Strommesseinrichtung und der oder jeder weiteren Strommesseinrichtung zur Übermittlung von Strommesswerten an die Überwachungsvorrichtung verlaufen innerhalb des Geräts/innerhalb des Abzweigelements. Für einen Verwender eines solchen Geräts/Abzweigelements ist die zusätzliche Schalt- und Schutzfunktion, nämlich die Überwachung jedes einzelnen Stromabgangs, vollständig transparent.

Bei einer alternativen Ausführungsform eines Abzweigelements mit einer Überwachungsvorrichtung wie hier und im Folgenden beschrieben ist das Abzweigelement mit einer Strommesseinheit verbunden und die Strommesseinheit umfasst die Strommesseinrichtung und die oder jede weitere Strommesseinrichtung. Es ergibt sich damit ein zweiteiliges Gerät. Bei einem Defekt entweder des Abzweigelements oder der Strommesseinheit kann jeder Teil des Geräts einzeln ersetzt werden. Die Signalpfade von der Strommesseinrichtung und der oder jeder weiteren Strommesseinrichtung zur Übermittlung von Strommesswerten an die Überwachungsvorrichtung sind mittels einer zumindest einseitig lösbaren Kabelverbindung zwischen dem Abzweigelement und der Strommesseinheit realisiert.

Bei einer vorteilhaften Ausführungsform des Abzweigelements oder des Überwachungsverfahrens werden zur Stromerhöhung mehrere Stromabgänge eines Abzweigelements oder alle Stromabgänge eines Abzweigelements zusammengefasst, also ausgangsseitig zusammengeschaltet. Die Überwachungsvorrichtung bildet und bewertet dann die Summe der gemessenen Ströme der jeweils parallelgeschalteten Stromabgänge. Die Bewertung erfolgt - in der Art und Weise wie zuvor beschrieben - in Form eines Vergleichs der ermittelten Summe mit einem vorgegebenen oder vorgebbaren Grenzwert und in Abhängigkeit vom Ergebnis des Vergleichs erfolgt eine Ansteuerung des Schaltelements. Der bei einer solchen Zusammenschaltung berücksichtigte Grenzwert ist optional ein spezifisch für die jeweilige Zusammenschaltung vorgegebener Grenzwert, also zum Beispiel ein einem Speicher fest eingeprägter Grenzwert. Alternativ ist der bei einer solchen Zusammenschaltung berücksichtigte Grenzwert ein zum Beispiel im Wege einer Parametrierung des Abzweigelements vorgebbarer Grenzwert, insbesondere ein einem Speicher im Rahmen einer Parametrierung variabel einprägbarer Grenzwert.

Bei einer weiteren vorteilhaften Ausführungsform des Abzweigelements oder des Überwachungsverfahrens ist dem ersten Stromabgang ein erstes Signalelement und dem oder jedem weiteren Stromabgang jeweils ein weiteres Signalelement zugeordnet. Mittels des ersten Signalelements oder des oder jedes weiteren Signalelements ist eine Überlastsituation in dem jeweiligen Stromabgang anzeigbar und wird beim Betrieb des Abzweigelements angezeigt. Eine entsprechende Ansteuerung eines jeweiligen Signalelements erfolgt zum Beispiel mittels der Überwachungsvorrichtung.

Im Falle eines Erreichens oder Überschreitens eines Grenzwerts kann dies damit spezifisch in Bezug auf denjenigen Stromabgang angezeigt werden, an dem die Überlastsituation eingetreten ist. Ohne eine solche Anzeige ist nach dem Eintreten einer Überlastsituation unmittelbar nur erkennbar, dass das Abzweigelement den ausgangsseitig anschließenden Lastbereich abgeschaltet hat und dass alle Verbraucher stromlos sind.

Optional kann zusätzlich zu dem Grenzwert, insbesondere einem für jeden Stromabgang spezifischen Grenzwert, zumindest ein unterhalb des Grenzwerts oder unterhalb des jeweiligen Grenzwerts liegender Ansprechwert berücksichtigt werden, zum Beispiel ein Ansprechwert, welcher um einen vorgegebenen oder vorgebbaren Prozentsatz (z.B. 5 %, 10 %) unter dem Grenzwert oder dem jeweiligen Grenzwert liegt. Beim Erreichen oder Überschreiten eines Ansprechwerts erfolgt eine spezifische Ansteuerung des jeweiligen Signalelements (z.B. Farbumschlag, Blinken etc.). Auf diese Weise kann bereits eine drohende Überlastsituation erkannt werden und es können möglicherweise noch Gegenmaßnahmen ergriffen werden, so dass eine vollständige Abschaltung des jeweiligen Lastbereichs unterbleibt.

Bei einer vorteilhaften Ausführungsform des Abzweigelements oder des Überwachungsverfahrens erfolgt anstelle einer Ansteuerung solcher Signalelemente oder zusätzlich zu einer Ansteuerung solcher Signalelemente eine Erzeugung eines zum Beispiel über einen Feldbus oder dergleichen an eine entfernte Station, zum Beispiel eine übergeordnete Einheit, übermittelbaren Signals. Ein solches Signal kodiert den jeweiligen Stromabgang, in dem die Überlastsituation aufgetreten ist oder für den sich eine drohende Überlastsituation abzeichnet. Mittels eines solchen Signals kann eine bestehende und/oder eine sich abzeichnende Überlastsituation auch an einem vom Ort des Abzweigelements entfernten Ort signalisiert werden, so dass von dort aus ggf. zentral Gegenmaßnahmen eingeleitet oder vorbereitet werden können. Zusätzlich oder alternativ wird für jeden Stromabgang ein solches Signal als Signal eines Digitalausgangs des Abzweigelements, also als Digitalsignal, an ein nachgelagertes Schütz übermittelt, welches auf den Erhalt eines solches Signals den jeweiligen Stromabgang und damit den oder jeden darüber gespeisten Verbraucher wegschaltet.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen. Vielmehr sind im Rahmen der vorliegenden Offenbarung durchaus auch Ergänzungen und Modifikationen möglich, insbesondere solche, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen. Es zeigen
- FIG 1: ein Gleichspannungsnetz,
- FIG 2: ein in einem Netz gemäß FIG 1 verwendbares Abzweigelement,
- FIG 3: ein Abzweigelement wie in FIG 2, jedoch mit einer mit dem Abzweigelement verbundenen und ansonsten von dem Abzweigelement beabstandeten Strommesseinheit, sowie
- FIG 4: eine schematisch vereinfachte Darstellung des hier vorgeschlagenen Überwachungsverfahrens.

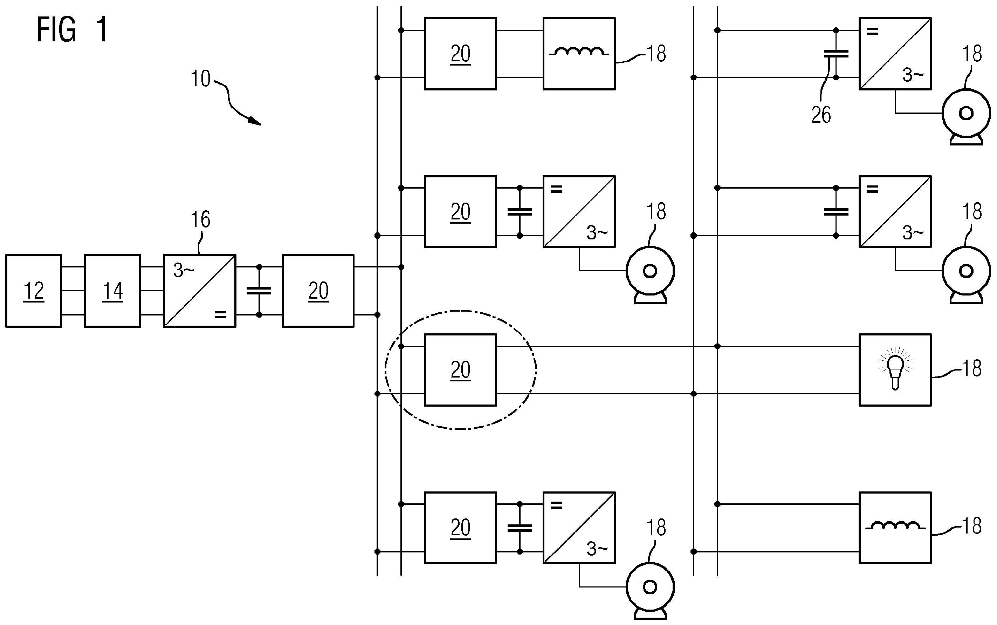

Die Darstellung in FIG 1 zeigt beispielhaft und schematisch vereinfacht eine Netzkonfiguration eines im Folgenden kurz als Netz 10 bezeichneten Gleichspannungsnetzes 10, welches exemplarisch zwei Netzebenen umfasst.

Das Netz 10 geht von einem Wechselspannungsnetz 12, einem nachfolgenden Schutzelement 14 (Wechselspannungsschalt- und - schutzelement) und einem wiederum daran anschließenden Gleichrichter 16 aus. Mittels des Netzes 10 wird eine Mehrzahl von (zum Teil über Wechselrichter angeschlossenen) Verbrauchern 18 mit elektrischer Energie versorgt.

Bei der gezeigten Konfiguration umfasst das Netz 10 eine Mehrzahl von im Folgenden kurz als Abzweigelement 20 bezeichneten Schutz- und Abzweigelementen. Von einem Abzweigelement 20 auf der Ausgangsseite des Gleichrichters 16 geht eine erste Netzebene aus. An diese sind weitere Abzweigelemente 20 angeschlossen. Die Verbraucher 18 - oder allgemeine eine Last - sind unmittelbar oder mittelbar, zum Beispiel über einen als Stützkondensator fungierenden Kondensator, angeschlossen. An eines der Abzweigelemente 20 - in der Darstellung in FIG 1 graphisch mittels einer Umrandung hervorgehoben - sind parallel mehrere Verbraucher 18 angeschlossen. Von diesem Abzweigelement 20 geht damit eine zweite Netzebene aus.

Mittels zumindest eines (nicht gezeigten) Abzweigelements 20 in der zweiten Netzebene kann eine dritte Netzebene eröffnet werden usw. Ausgehend von der ersten, zweiten, dritten usw. Netzebene kann mittels eines (nicht gezeigten) Abzweigelements 20 eine weitere Netzebene eröffnet werden, welche hierarchisch eine weitere zweite, dritte usw. Netzebene bildet.

Derzeit übliche Abzweigelemente 20 messen den Summenstrom aller angeschlossenen Verbraucher 18. Dies ist zum Beispiel mittels genau eines Stromwandlers (nicht gezeigt) im Abzweigelement 20 möglich. Eine jeweilige Verteilung des Stroms auf die einzelnen angeschlossenen Verbraucher 18 kennt das Abzweigelement 20 nicht. Im Rahmen seiner Schutzfunktion schützt das Abzweigelement 20 zwar im Falle eines Kurzschlusses, weil der Strom durch das Abzweigelement 20 unabhängig vom Ort des Kurzschlusses immer groß genug wird. Eine Überwachung der einzelnen Leitungen zu den angeschlossenen Verbrauchern 18 (Leitungsschutz oder Geräteschutz) ist allerdings nicht möglich. Dies ist vor allem dann kritisch, wenn an ein Abzweigelement 20 auch Verbraucher 18 mit kleiner Leistung über Kabel mit entsprechend eher geringem Querschnitt angeschlossen sind.

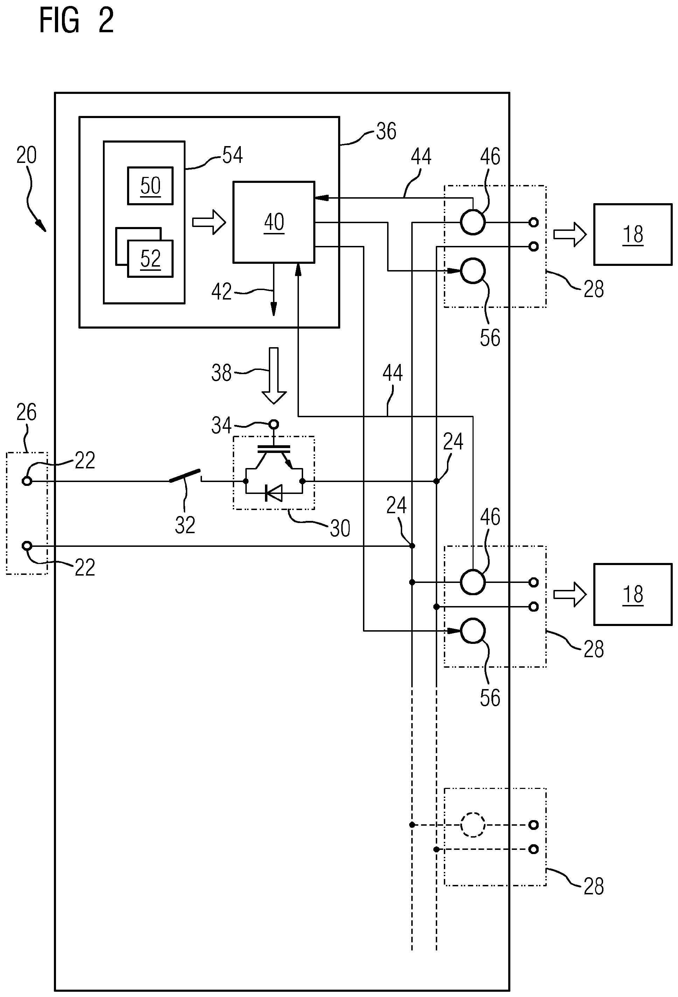

Die Darstellung in FIG 2 zeigt schematisch vereinfacht eine Ausführungsform eines Abzweigelements 20 nach dem hier vorgeschlagenen Ansatz.

Das Abzweigelement 20 ist auf einer durch Eingangskontakte 22 gebildeten Eingangsseite (Eingang 22) innerhalb eines jeweiligen Netzes 10 an eine Eingangsspannung, insbesondere eine Gleichspannung, anschließbar und im Betrieb an eine Eingangsspannung angeschlossen. Auf einer durch Ausgangskontakte 24 gebildeten Ausgangsseite (Ausgang 24) ist an das Abzweigelement 20 (unmittelbar oder mittelbar) ein Verbraucher 18 (FIG 1) anschließbar und zum Betrieb des Verbrauchers 18 ist dieser an ein Abzweigelement 20 angeschlossen, insbesondere über einen auf der Ausgangsseite des Abzweigelements 20 dem Verbraucher 18 vorgeschalteten Stützkondensator (siehe FIG 1; dort nicht bezeichnet).

Die Eingangskontakte 22 des Abzweigelements 20 fungieren als Stromzugang 26 des Abzweigelements 20. Zum Anschluss zumindest eines Verbrauchers 18 an das Abzweigelement 20 ist der Ausgang 24 auf entsprechende Anschlusskontakte weitergeführt, wobei diese als Stromabgang 28 fungieren. Bei einem Abzweigelement 20, welches den gleichzeitigen Anschluss mehrerer Verbraucher 18 erlaubt, ist der Ausgang 24 auf mehrere parallele Stromabgänge 28 mit jeweils paarigen Anschlusskontakten weitergeführt. In der Darstellung in FIG 2 ist dies für zwei parallele Stromabgänge 28 gezeigt und ein möglicher weiterer Stromabgang 28 ist angedeutet. Das Abzweigelement 20 kann zwei, drei, vier oder mehr Stromabgänge 28 aufweisen.

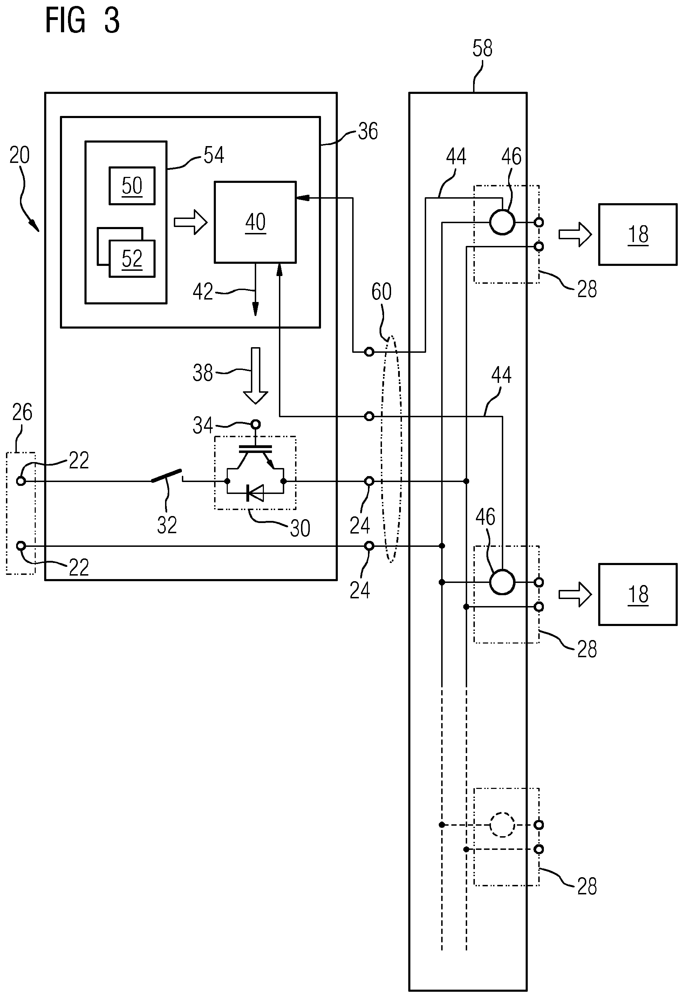

Bei der in FIG 2 gezeigten Ausführungsform sind der Stromabgang 28 und der zumindest eine weitere Stromabgang 28 einem Abzweigelement 20 zugeordnet, indem das Abzweigelement 20 diese umfasst. Bei der später gezeigten Ausführungsform (FIG 3) sind dem Abzweigelement 20 ein Stromabgang 28 und zumindest ein weiterer Stromabgang 28 zugeordnet, indem sie elektrisch mit dem Abzweigelement 20 verbunden sind.

Das Abzweigelement 20 umfasst in grundsätzlich an sich bekannter Art zumindest ein elektrisch ansteuerbares Schaltelement 30. Als Schaltelement 30 fungiert zum Beispiel zumindest ein Halbleiterschalter, insbesondere ein Leistungshalbleiterschalter oder alternativ eine bidirektional leit- und sperrfähige Zusammenschaltung zweier Leistungshalbleiterschalter. Optional umfasst das Abzweigelement 20 in ebenfalls grundsätzlich an sich bekannter Art ein weiteres Schaltelement 32. Dieses ist normalerweise geschlossen.

Ein Schaltzustand (leitend, nicht leitend) des Schaltelements 30 ist über einen Ansteuereingang 34 des Schaltelements 30 beeinflussbar. Der Ansteuereingang 34 wird mit einem von einer Ansteuereinheit 36 erzeugten Ansteuersignal 38 beaufschlagt. Das Ansteuersignal 38 ist in der Darstellung in FIG 2 durch einen zum Ansteuereingang 34 weisenden Blockpfeil veranschaulicht.

Zum Trennen eines oder jedes an das oder ein Abzweigelement 20 angeschlossenen Verbrauchers 18 und damit vom Abzweigelement 20 und insgesamt vom Netz 10 wird das Schaltelement 30 mit einem Ansteuersignal 38 angesteuert, welches einen Schaltzustand des Schaltelements 30 bewirkt, bei dem auf der Ausgangsseite des Abzweigelements 20 - und damit an jedem Stromabgang 28 - eine an dessen Eingangsseite anliegende Spannung verschwindet; das Schaltelement 30 ist elektrisch "offen". Dies wird im Folgenden als Öffnen des Abzweigelements 20 bezeichnet. Ein automatisches Öffnen des Abzweigelements 20 erfolgt beispielsweise dann, wenn mittels einer an sich bekannten Sensorik automatisch eine Überstrom- oder Fehlerstromsituation erkannt wird. Ein Öffnen des Abzweigelements 20 kann in grundsätzlich an sich bekannter Art und Weise auch aufgrund eines externen Signals ausgelöst werden, wenn der oder jeder an das Abzweigelement 20 angeschlossene Verbraucher 18 abgeschaltet werden soll (wenn ein sogenannter Lastbereich abgeschaltet werden soll).

Im fehlerfreien Fall wird zur Ankopplung des oder jedes an das Abzweigelement 20 angeschlossenen Verbrauchers 18 an das jeweilige Netz 10 das Schaltelement 30 mit einem Ansteuersignal 38 angesteuert, welches einen Schaltzustand des Schaltelements 30 bewirkt, bei dem die an der Eingangsseite des **Ab**zweigelements 20 anliegende Spannung an dessen Ausgangsseite - und damit an jedem Stromabgang 28 - erscheint; das Schaltelement 30 ist elektrisch "geschlossen". Dies wird im Folgenden als Schließen des Abzweigelements 20 bezeichnet.

Bei dem hier vorgeschlagenen Abzweigelement 20 ist vorgesehen, dass einerseits ein Summenstrom, also die Summe aller Ströme zu allen an das Abzweigelement 20 angeschlossenen Verbrauchern 18, überwacht wird und dass andererseits der Strom zu jedem einzelnen Verbraucher 18 überwacht wird. Anders formuliert werden bezüglich aller Stromabgänge 28 einerseits die Summe aller Ströme und andererseits jeder einzelne Strom überwacht.

Für diese Überwachung ist eine als Überwachungsvorrichtung 40 fungierende Überwachungseinheit 40 vorgesehen. Diese ist zum Beispiel als Bestandteil der Ansteuereinheit 36 implementiert. Die Überwachungseinheit 40 ist dafür bestimmt und eingerichtet, in Abhängigkeit von einer Überwachung des Summenstroms sowie einer Überwachung des Stroms zu jedem einzelnen Verbraucher 18 ein Ausgangssignal 42 zu erzeugen. Im Betrieb erzeugt die Überwachungseinheit 40 ein solches Ausgangssignal 42. Das Ausgangssignal 42 wird zum Beispiel von der Ansteuereinheit 36 ausgewertet. Dann erzeugt die Ansteuereinheit 36 in Abhängigkeit von einem Status des Ausgangssignals 42 ein entsprechendes Ansteuersignal 38. Alternativ ist das Ausgangssignal 42 direkt auf den Ausgang, an dem die Ansteuereinheit 36 das Ansteuersignal 38 ausgibt, durchgeschaltet. Das Ausgangssignal 42 ist also unmittelbar oder zumindest mittelbar zum Öffnen oder Schließen des Abzweigelements 20 wirksam.

Die Überwachungseinheit 40 erzeugt das Ausgangssignal 42 in Abhängigkeit von ihr eingangsseitig von jedem Stromabgang 28 zugeführten Eingangssignalen, nämlich Strommesswerten 44 oder daraus abgeleiteten Stromwerten. Die Strommesswerte 44 stammen von Strommesseinrichtungen 46 in jedem Stromabgang 28 des Abzweigelements 20. Bei der gezeigten Ausführungsform umfasst das Abzweigelement 20 zumindest zwei Stromabgänge 28, also einen ersten Stromabgang 28 und zumindest einen weiteren Stromabgang 28. Jedem Stromabgang 28 ist eine Strommesseinrichtung 46 zugeordnet. Also ist dem ersten Stromabgang 28 eine erste Strommesseinrichtung 46 zugeordnet und dem oder jedem weiteren Stromabgang 28 ist eine weitere Strommesseinrichtung 46 bzw. jeweils eine weitere Strommesseinrichtung 46 zugeordnet. Mittels der ersten Strommesseinrichtung 46 und der oder jeder weiteren Strommesseinrichtung 46 ist jeweils ein Strommesswert erfassbar und an die Überwachungseinheit 40 übermittelbar. Beim Betrieb des Abzweigelements 20 wird mittels der ersten Strommesseinrichtung 46 und der oder jeder weiteren Strommesseinrichtung 46 jeweils ein Strommesswert 44 erfasst und an die Überwachungseinheit 40 weitergeleitet.

Die Überwachungseinheit 40 bildet die Summe aller Strommesswerte 44 - also die Summe des ersten Strommesswerts 44 und des oder jedes weiteren Strommesswerts 44 - und vergleicht diese Summe mit einem vorgegebenen oder vorgebbaren Schwellwert 50. Des Weiteren vergleicht die Überwachungseinheit 40 jeden einzelnen Strommesswert 44 oder einen daraus abgeleiteten Stromwert - also den ersten Strommesswert 44 und den oder jeden weiteren Strommesswert 44 oder daraus jeweils abgeleitete Stromwerte - mit einem für den jeweiligen Stromabgang 28 vorgegebenen oder vorgebbaren Grenzwert 52. Das Schaltelement 30 des Abzweigelements 20 ist durch die Überwachungseinheit 40 in Abhängigkeit vom Ergebnis jedes Vergleichs ansteuerbar und das Schaltelement 30 wird beim Betrieb des Abzweigelements 20 durch die Überwachungseinheit 40 in Abhängigkeit vom Ergebnis jedes Vergleichs angesteuert. Die Ansteuerung erfolgt durch Ausgabe eines Ausgangssignals 42 der Überwachungseinheit 40. Der Status des Ausgangssignals 42 hängt vom Ergebnis der Vergleiche ab. Im Falle eines Erreichens oder Überschreitens des Schwellwerts 50 oder eines Grenzwerts 52 bei den Vergleichen wird ein Ausgangssignal 42 erzeugt, welches ein Öffnen des Schaltelements 30 des Abzweigelements 20 bewirkt. Im Falle eines Erreichens oder Überschreitens des Schwellwerts 50 oder eines Grenzwerts 52 bei den Vergleichen werden also aufgrund der Überwachung der Strommesswerte 44 in jedem Stromabgang 28 mittels der Überwachungseinheit 40 automatisch alle an das Abzweigelement 20 angeschlossenen Verbraucher 18 vom Netz 10 getrennt.

Jeder Strommesswert 44 stammt von einem Stromabgang 28, nämlich von der Strommesseinrichtung 46 im jeweiligen Stromabgang 28. Jeder Strommesswert 44 kodiert den über den jeweiligen Stromabgang 28 fließenden und dort mittels der jeweiligen Strommesseinrichtung 46 erfassten Strom. Als Strommesseinrichtung 46 kommt ein Stromwandler in Betracht, zum Beispiel ein Hall-Sensor, ein Messshunt, ein Kompensationsstromwandler oder dergleichen.

Der Schwellwert 50 ist zum Beispiel in einem von der Ansteuereinheit 36 umfassten oder mit der Ansteuereinheit 36 in an sich bekannter Art kommunikativ verbundenen Speicher 54 abgelegt. Jeder Grenzwert 52 - jeweils ein Grenzwert 52 für jeden Stromabgang 28 - ist zum Beispiel ebenfalls in einem von der Ansteuereinheit 36 umfassten oder mit der Ansteuereinheit 36 in an sich bekannter Art kommunikativ verbundenen Speicher 54 abgelegt, insbesondere in demselben Speicher 54, in dem auch der Schwellwert 50 abgelegt ist. Der Schwellwert 50 und/oder jeder Grenzwert 52 ist zum Beispiel vorgegeben, also zum Beispiel dem Speicher 54 unveränderbar eingeprägt. Alternativ kann der Schwellwert 50 und/oder jeder Grenzwert 52 auch vorgebbar sein, also durch eine einem Verwender des Abzweigelements 20 zugängliche Parametrisierung im Speicher 54 veränderbar sein.

Zum Vergleich der Summe aller Strommesswerte 44 mit dem Schwellwert 50 und/oder zum Vergleich jedes Strommesswerts 44 oder eines daraus abgeleiteten Stromwerts mit jeweils einem Grenzwert 52 umfasst die Überwachungseinheit 40 zum Beispiel einen Komparator (nicht gezeigt) oder eine entsprechende Funktionseinheit oder eine entsprechende Funktionalität in Soft- und/oder Firmware.

Die Darstellung in FIG 2 zeigt eine Ausführungsform, bei der jedem Stromabgang 28 ein Signalelement 56 zugeordnet ist, zum Beispiel ein optisches Signalelement in Form einer LED oder dergleichen und/oder ein akustisches Signalelement. Ein Signalelement 56 wird von der Überwachungseinheit 40 in Abhängigkeit vom Ergebnis des Vergleichs des jeweiligen Strommesswerts 44 mit dem Grenzwert 52 angesteuert. Mittels des Signalelements 56 ist also eine Überlastsituation in dem jeweiligen Stromabgang 28 anzeigbar. Alternativ oder zusätzlich zur Erzeugung eines solchen Signals zur Ansteuerung eines Signalelements 56 erzeugt die Überwachungseinheit 40 zumindest ein über einen Feldbus oder dergleichen übermittelbares Signal, welches auf diesem Wege zu einem vom Abzweigelement 20 entfernten Empfänger übermittelbar ist und dort eine Überlastsituation in dem jeweiligen Stromabgang 28 anzeigt.

Bei der in FIG 2 gezeigten Ausführungsform des Abzweigelements 20 ist dieses in Form einer das Schaltelement 30, die Ansteuereinheit 36, insbesondere eine Ansteuereinheit 36 in Form einer die Überwachungseinheit 40 umfassenden Ansteuereinheit 36, und die jedem Stromabgang 28 zugeordnete Strommesseinrichtung 46 umfassenden Einheit gezeigt. Ein solches Abzweigelement 20 ist optional in Form eines das Schaltelement 30, die Ansteuereinheit 36 und jede Strommesseinrichtung 46 sowie dazwischen bestehende Leitungsverbindungen in einem gemeinsamen Gehäuse einschließenden Geräts realisiert.

Die Darstellung in FIG 3 zeigt eine alternative Ausführungsform, bei der die Strommesseinrichtungen 46 in einer Strommesseinheit 58 zusammengefasst sind. Diese ist zum Beispiel mittels eines zumindest einseitig, also auf Seiten des Abzweigelements 20 und/oder auf Seiten der Strommesseinheit 58, lösbaren Kabels 60 mit dem Abzweigelement 20 verbindbar und im Betrieb mit dem Abzweigelement 20 verbunden. Über das Kabel 60 oder alternativ auch über mehrere einzelne Kabel/- verbindungen erfolgt die Weiterleitung der elektrischen Energie zu den Stromabgängen 28 und die Weiterleitung der Strommesswerte 44 von den Stromabgängen 28 zum Abzweigelement 20, nämlich zur Überwachungseinheit 40. Alternativ zu einer Kabelverbindung oder mehreren Kabelverbindungen kommt auch eine steckbare Variante in Betracht, bei welcher das Abzweigelement 20 und die Strommesseinheit 58 mittels grundsätzlich an sich bekannter Steckkontakte oder dergleichen unmittelbar elektrisch leitend miteinander verbindbar sind.

Bei der Ausführungsform mit in einer Strommesseinheit 58 zusammengefassten Strommesseinrichtungen 46 ergeben sich zwei voneinander unabhängige und beabstandet platzierbare Einheiten, insbesondere Einheiten mit jeweils einem eigenen Gehäuse, nämlich als erste Einheit das Abzweigelement 20 mit dem Schaltelement 30 und der Ansteuereinheit 36, insbesondere einer Ansteuereinheit 36 in Form einer die Überwachungseinheit 40 umfassenden Ansteuereinheit 36, und als zweite Einheit die Strommesseinheit 58 mit den Stromabgängen 28 und den jedem Stromabgang 28 zugeordneten Strommesseinrichtungen 46.

Bei einer weiteren Ausführungsform sind anstelle genau einer Strommesseinheit 58 zwei, drei usw. separate und jeweils über eine Kabelverbindung, eine Steckverbindung oder dergleichen mit dem Abzweigelement 20 Strommesseinheiten 58 mit jeweils einer Strommesseinrichtung 46 vorgesehen. Jede derartige Strommesseinheit 58 ist mit ihrer Strommesseinrichtung 46 genau einem Stromabgang 28 zugeordnet.

Die Ausführungen im Zusammenhang mit FIG 2 bezüglich der Ansteuerung eines Signalelements 56 oder der Erzeugung eines über einen Bus an einen entfernten Empfänger übermittelbaren Signals gelten entsprechend auch für die in FIG 3 gezeigte Ausführungsform.

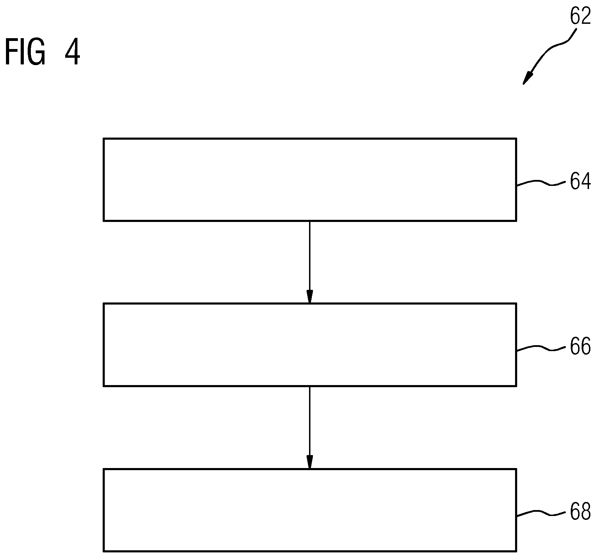

Der Betrieb des Abzweigelements 20 und die Überwachung mittels der Überwachungseinheit 40, also die Ansteuerung des Schaltelements 30 in Abhängigkeit vom Ergebnis der mittels der Überwachungseinheit 40 durchgeführten Vergleiche, ist abschließend als schematisch vereinfachte Darstellung des hier vorgeschlagenen Überwachungsverfahrens 62 in FIG 4 gezeigt.

In einem ersten Schritt 64 wird mittels der ersten Strommesseinrichtung 46 sowie der oder jeder weiteren Strommesseinrichtung 46 jeweils ein Strommesswert 44 erfasst. In einem zweiten Schritt 66 wird eine Summe der erfassten Strommesswerte 44 mit einem vorgegebenen oder vorgebbaren Schwellwert 50 verglichen und in Abhängigkeit vom Ergebnis des Vergleichs das Schaltelement 30 des Abzweigelements 20 angesteuert. In einem dritten Schritt 68 wird jeder einzelne erfasste Strommesswert 44 oder ein daraus abgeleiteter Stromwert mit einem vorgegebenen oder vorgebbaren Grenzwert 52 verglichen und in Abhängigkeit vom Ergebnis jedes Vergleichs das Schaltelement 30 des Abzweigelements 20 angesteuert. Die hier gezeigte Reihenfolge des zweiten und dritten Schritts 66, 68 kann auch vertauscht sein. Optional ist eine gleichzeitige oder quasi-gleichzeitige Ausführung des zweiten und dritten Schritts 66, 68 vorgesehen.

Die Überwachung mittels der Überwachungseinheit 40 entsprechend dem hier vorgeschlagenen Ansatz oder einzelner oder mehrerer Ausgestaltungen erfolgt bevorzugt regelmäßig zu zum Beispiel nach Art einer Abtastfrequenz vorgegebenen oder vorgebbaren äquidistanten Zeitpunkten. Zu jedem sich danach ergebenden Zeitpunkt wird die Überwachung durch Ausführung des Überwachungsverfahrens 62 durchgeführt. Optional ist die Überwachung mittels der Überwachungseinheit 40 aktivierbar und deaktivierbar, so dass eine zyklische Überwachung nur dann stattfindet, wenn die Überwachung aktiviert ist. Optional wird die zyklische Überwachung automatisch aktiviert, zum Beispiel als Ergebnis einer automatischen Detektion zumindest eines an einen Stromabgang 28 angeschlossenen Verbrauchers 18.

Das Überwachungsverfahren 62 ist zum Beispiel in Hardware oder in Firmware, zum Beispiel mittels eines FPGA oder dergleichen, oder in Firm- und Software oder in Software implementiert.

Abschließend lässt sich der hier vorgeschlagene Ansatz kurz wie folgt zusammenfassen: Angegeben werden eine Überwachungseinheit/Überwachungsvorrichtung 40 zur automatischen Überwachung eines ersten Stromabgangs 28 sowie zumindest eines weiteren Stromabgangs 28 im Anschluss an ein zumindest ein elektrisch schaltbares Schaltelement 30 umfassendes Abzweigelement 20, ein Abzweigelement 20 mit einer solchen Überwachungseinheit/Überwachungsvorrichtung 40, insbesondere als integraler Bestandteil des Abzweigelements 20, sowie ein Verfahren zur automatischen Überwachung eines ersten Stromabgangs 28 sowie zumindest eines weiteren Stromabgangs 28 im Anschluss an ein zumindest ein elektrisch schaltbares Schaltelement 30 umfassendes Abzweigelement 20, insbesondere als Verfahren zum Betrieb der Überwachungseinheit/Überwachungsvorrichtung 40 oder als Verfahren zum Betrieb des eine Überwachungseinheit/Überwachungsvorrichtung 40 umfassenden Abzweigelements 20. Das Abzweigelement 20 weist einen Stromzugang 26 auf und dem Abzweigelement 20 sind ein erster Stromabgang 28 sowie zumindest ein weiterer Stromabgang 28 zugeordnet. Dem ersten Stromabgang 28 ist eine erste Strommesseinrichtung 46 zugeordnet und dem weiteren Stromabgang 28 ist eine weitere Strommesseinrichtung 46 oder jedem weiteren Stromabgang 28 ist jeweils eine weitere Strommesseinrichtung 46 zugeordnet. Mittels der ersten Strommesseinrichtung 46 sowie der oder jeder weiteren Strommesseinrichtung 46 ist jeweils ein Strommesswert 44 erfassbar und wird beim Betrieb des Abzweigelements 20 erfasst. Mittels der Überwachungsvorrichtung 40 ist ein Vergleich einer Summe der erfassten Strommesswerte 44 mit einem vorgegebenen oder vorgebbaren Schwellwert 50 durchführbar und in Abhängigkeit vom Ergebnis des Vergleichs ist das Schaltelement 30 des Abzweigelements 20 ansteuerbar und im Rahmen des Überwachungsverfahrens 62 wird, insbesondere mittels der Überwachungsvorrichtung 40, ein Vergleich einer Summe der erfassten Strommesswerte 44 mit einem vorgegebenen oder vorgebbaren Schwellwert 50 durchgeführt und in Abhängigkeit vom Ergebnis des Vergleichs das Schaltelement 30 des Abzweigelements 20 angesteuert. Weiter ist mittels der Überwachungsvorrichtung 40 ein Vergleich jedes einzelnen erfassten Strommesswerts 44 oder eines daraus abgeleiteten Stromwerts mit einem vorgegebenen oder vorgebbaren Grenzwert 52 durchführbar und in Abhängigkeit vom Ergebnis jedes Vergleichs ist das Schaltelement 30 des Abzweigelements 20 ansteuerbar und im Rahmen des Überwachungsverfahrens 62 wird, insbesondere mittels der Überwachungsvorrichtung 40, ein Vergleich jedes einzelnen erfassten Strommesswerts 44 oder eines daraus abgeleiteten Stromwerts mit einem vorgegebenen oder vorgebbaren Grenzwert 52 durchgeführt und in Abhängigkeit vom Ergebnis jedes Vergleichs das Schaltelement 30 des Abzweigelements 20 angesteuert.

## Patentansprüche

1. Abzweigelement (20), umfassend
ein elektrisch schaltbares Schaltelement (30) und
eine Überwachungsvorrichtung (40) zur automatischen Überwachung eines ersten Stromabgangs (28) sowie zumindest eines weiteren Stromabgangs (28) im Anschluss an das Abzweigelement (20) in einem Stromnetz (10),
wobei das Abzweigelement (20) einen Stromzugang (26) aufweist,
wobei dem ersten Stromabgang (28) eine erste Strommesseinrichtung (46) zugeordnet ist und dem oder jedem weiteren Stromabgang (28) jeweils eine weitere Strommesseinrichtung (46) zugeordnet ist,
wobei mittels der ersten Strommesseinrichtung (46) sowie der oder jeder weiteren Strommesseinrichtung (46) jeweils ein Strommesswert (44) erfassbar ist,
wobei die Überwachungsvorrichtung (40) dazu eingerichtet ist, einen Vergleich einer Summe der erfassten Strommesswerte (44) mit einem vorgegebenen oder vorgebbaren Schwellwert (50) durchzuführen und in Abhängigkeit vom Ergebnis des Vergleichs das elektrisch schaltbare Schaltelement (30) des Abzweigelements (20) anzusteuern,
**dadurch gekennzeichnet, dass** die Überwachungsvorrichtung (40) dazu eingerichtet ist, einen Vergleich jedes einzelnen erfassten Strommesswerts (44) oder eines daraus abgeleiteten Effektiv- oder I²t-Werts mit einem vorgegebenen oder vorgebbaren Grenzwert (52) durchzuführen und in Abhängigkeit vom Ergebnis jedes Vergleichs das elektrisch schaltbare Schaltelement (30) des Abzweigelements (20) anzusteuern.

2. Abzweigelement (20) nach Anspruch 1, wobei für den ersten Stromabgang (28) und den oder jeden weiteren Stromabgang (28) jeweils ein eigener Grenzwert (52) vorgegeben oder vorgebbar ist.

3. Abzweigelement (20) nach einem der vorhergehenden Ansprüche, wobei das Abzweigelement (20) die Strommesseinrichtungen (46) umfasst.

4. Abzweigelement (20) nach einem der Ansprüche 1 und 2, wobei das Abzweigelement mit einer Strommesseinheit (58) verbunden ist und wobei die Strommesseinheit (58) die Strommesseinrichtungen (46) umfasst.

5. Abzweigelement (20) nach einem der vorhergehenden Ansprüche,
mit einem dem ersten Stromabgang (28) zugeordneten ersten Signalelement (56) und jeweils einem dem oder jedem weiteren Stromabgang (28) zugeordneten weiteren Signalelement (56),
wobei mittels des ersten Signalelements (56) oder des oder jedes weiteren Signalelements (56) eine Überlastsituation in dem jeweiligen Stromabgang (28) anzeigbar ist.

6. Abzweigelement (20) nach einem der vorhergehenden Ansprüche,
wobei im Falle einer Überlastsituation in einem der Stromabgänge (28) mittels der Überwachungsvorrichtung (40) ein den jeweiligen Stromabgang (28) kodierendes und über einen Feldbus übermittelbares Signal generierbar ist.

7. Verfahren zur automatischen Überwachung eines ersten Stromabgangs (28) sowie zumindest eines weiteren Stromabgangs (28) im Anschluss an ein ein elektrisch schaltbares Schaltelement (30) umfassendes Abzweigelement (20) in einem Stromnetz (10),
wobei das Abzweigelement (20) einen Stromzugang (26) aufweist,
wobei dem ersten Stromabgang (28) eine erste Strommesseinrichtung (46) zugeordnet ist und dem oder jedem weiteren Stromabgang (28) jeweils eine weitere Strommesseinrichtung (46) zugeordnet ist,
wobei mittels der ersten Strommesseinrichtung (46) sowie der oder jeder weiteren Strommesseinrichtung (46) jeweils ein Strommesswert (44) erfasst wird,
wobei eine Summe der erfassten Strommesswerte (44) mit einem vorgegebenen oder vorgebbaren Schwellwert (50) verglichen und in Abhängigkeit vom Ergebnis des Vergleichs das elektrisch schaltbare Schaltelement (30) des Abzweigelements (20) angesteuert wird,
**dadurch gekennzeichnet, dass**
jeder einzelne erfasste Strommesswert (44) oder ein daraus abgeleiteter Effektiv- oder I²t-Wert mit einem vorgegebenen oder vorgebbaren Grenzwert (52) verglichen und in Abhängigkeit vom Ergebnis jedes Vergleichs das elektrisch schaltbare Schaltelement (30) des Abzweigelements (20) angesteuert wird.

8. Verfahren nach Anspruch 7,
wobei für den ersten Stromabgang (28) und den oder jeden weiteren Stromabgang (28) jeweils ein eigener Grenzwert (52) vorgegeben oder vorgebbar ist.

9. Verfahren nach Anspruch 7 oder 8,
wobei zumindest zwei Stromabgänge (28) des Abzweigelements (20) ausgangsseitig zusammengeschaltet sind und
wobei eine Summe der erfassten Strommesswerte (44) der zusammengeschalteten Stromabgänge (28) mit einem vorgegebenen oder vorgebbaren Grenzwert (52) verglichen und in Abhängigkeit vom Ergebnis jedes Vergleichs das elektrisch schaltbare Schaltelement (30) des Abzweigelements (20) angesteuert wird.

10. Verfahren nach Anspruch 7, 8 oder 9,
mit einem dem ersten Stromabgang (28) zugeordneten ersten Signalelement (56) und jeweils einem dem oder jedem weiteren Stromabgang (28) zugeordneten weiteren Signalelement (56),
wobei mittels des ersten Signalelements (56) oder des oder jedes weiteren Signalelements (56) eine Überlastsituation in dem jeweiligen Stromabgang (28) angezeigt wird.

11. Verfahren nach Anspruch 7, 8, 9 oder 10,
wobei im Falle einer Überlastsituation in einem der Stromabgänge (28) die Überwachungsvorrichtung (40) ein den jeweiligen Stromabgang (28) kodierendes Signal generiert und dieses über einen Feldbus an einen entfernten Empfänger übermittelt.

## Claims

1. Branch element (20), comprising
an electrically switchable switching element (30) and
a monitoring apparatus (40) for automatically monitoring a first outgoing current feeder (28) and at least one further outgoing current feeder (28) downstream of the branch element (20) in an electricity grid (10),
wherein the branch element (20) has an incoming current feeder (26),
wherein a first current measuring device (46) is assigned to the first outgoing current feeder (28) and a respective further current measuring device (46) is assigned to the or each further outgoing current feeder (28),
wherein a respective current measurement value (44) can be recorded by means of the first current measuring device (46) and the or each further current measuring device (46),
wherein the monitoring apparatus (40) is configured to carry out a comparison of a sum of the recorded current measurement values (44) with a predefined or predefinable threshold value (50) and to control the electrically switchable switching element (30) of the branch element (20) depending on the result of the comparison, **characterized in that**
the monitoring apparatus (40) is configured to carry out a comparison of each individual recorded current measurement value (44) or of a root-mean-square or I²t value derived therefrom with a predefined or predefinable limit value (52) and to control the electrically switchable switching element (30) of the branch element (20) depending on the result of each comparison.

2. Branch element (20) according to Claim 1, wherein a respective dedicated limit value (52) is predefined or predefinable for the first outgoing current feeder (28) and the or each further outgoing current feeder (28).

3. Branch element (20) according to either of the preceding claims, wherein the branch element (20) comprises the current measuring devices (46).

4. Branch element (20) according to either of Claims 1 and 2, wherein the branch element is connected to a current measuring unit (58) and wherein the current measuring unit (58) comprises the current measuring devices (46).

5. Branch element (20) according to any of the preceding claims,
having a first signal element (56) assigned to the first outgoing current feeder (28) and a respective further signal element (56) assigned to the or each further outgoing current feeder (28),
wherein an overload situation in the respective outgoing current feeder (28) can be indicated by means of the first signal element (56) or the or each further signal element (56).

6. Branch element (20) according to any of the preceding claims,
wherein, in the case of an overload situation in one of the outgoing current feeders (28), a signal which encodes the respective outgoing current feeder (28) and can be transmitted via a field bus can be generated by means of the monitoring apparatus (40).

7. Method for automatically monitoring a first outgoing current feeder (28) and at least one further outgoing current feeder (28) downstream of a branch element (20) comprising an electrically switchable switching element (30) in an electricity grid (10),
wherein the branch element (20) has an incoming current feeder (26),
wherein a first current measuring device (46) is assigned to the first outgoing current feeder (28) and a respective further current measuring device (46) is assigned to the or each further outgoing current feeder (28),
wherein a respective current measurement value (44) is recorded by means of the first current measuring device (46) and the or each further current measuring device (46),
wherein a sum of the recorded current measurement values (44) is compared with a predefined or predefinable threshold value (50) and the electrically switchable switching element (30) of the branch element (20) is controlled depending on the result of the comparison, **characterized in that**
each individual recorded current measurement value (44) or a root-mean-square or I²t value derived therefrom is compared with a predefined or predefinable limit value (52) and the electrically switchable switching element (30) of the branch element (20) is controlled depending on the result of each comparison.

8. Method according to Claim 7,
wherein a respective dedicated limit value (52) is predefined or predefinable for the first outgoing current feeder (28) and the or each further outgoing current feeder (28).

9. Method according to Claim 7 or 8,
wherein at least two outgoing current feeders (28) of the branch element (20) are interconnected on the output side, and
wherein a sum of the recorded current measurement values (44) of the interconnected outgoing current feeders (28) is compared with a predefined or predefinable limit value (52) and the electrically switchable switching element (30) of the branch element (20) is controlled depending on the result of each comparison.

10. Method according to Claim 7, 8 or 9,
having a first signal element (56) assigned to the first outgoing current feeder (28) and a respective further signal element (56) assigned to the or each further outgoing current feeder (28),
wherein an overload situation in the respective outgoing current feeder (28) is indicated by means of the first signal element (56) or the or each further signal element (56).

11. Method according to Claim 7, 8, 9 or 10,
wherein, in the case of an overload situation in one of the outgoing current feeders (28), the monitoring apparatus (40) generates a signal which encodes the respective outgoing current feeder (28), and transmits said signal to a remote receiver via a field bus.

## Revendications

1. Elément (20) de dérivation, comprenant
un élément (30) de circuit connectable électriquement et un dispositif (40) de contrôle pour le contrôle automatique d'un premier départ (28) de courant, ainsi qu'au moins un autre départ (28) de courant en connexion avec l'élément (20) de dérivation dans un réseau (10) de courant,
dans lequel l'élément (20) de dérivation a une arrivée (26) de courant,
dans lequel, au premier départ (28) de courant, est affecté un premier dispositif (46) de mesure du courant et au ou à chaque autre départ (28) de courant est affecté respectivement un autre dispositif (46) de mesure du courant,
dans lequel, au moyen du premier dispositif (46) de mesure du courant ainsi que du ou de chaque autre dispositif (46) de mesure du courant, une valeur (44) de mesure du courant peut être détectée respectivement,
dans lequel le dispositif (40) de contrôle est agencé pour effectuer une comparaison d'une somme des valeurs (44) de mesure de courant détectées à une valeur (50) de seuil donnée à l'avance ou pouvant l'être et pour commander, en fonction du résultat de la comparaison, l'élément (30) de circuit connectable électriquement de l'élément (20) de dérivation,
**caractérisé en ce que**
le dispositif (40) de contrôle est agencé pour effectuer une comparaison de chaque valeur (44) de mesure du courant individuel détecté ou d'une valeur effective ou I²t effective, qui s'en déduit, à une valeur (52) limite donnée à l'avance ou pouvant l'être et pour commander, en fonction du résultat de chaque comparaison, l'élément (30) de circuit connectable électriquement de l'élément (20) de dérivation.

2. Elément (20) de dérivation suivant la revendication 1, dans lequel, pour le premier départ (28) de courant et le ou chaque autre départ (28) de courant, une valeur (52) limite propre est donnée à l'avance respectivement ou peut l'être.

3. Elément (20) de dérivation suivant l'une des revendications précédentes, dans lequel l'élément (20) de dérivation comprend les dispositifs (46) de mesure du courant.

4. Elément (20) de dérivation suivant l'une des revendications 1 et 2, dans lequel l'élément de dérivation est connecté à une unité (58) de mesure du courant et dans lequel l'unité (58) de mesure du courant comprend les dispositifs (46) de mesure du courant.

5. Elément (20) de dérivation suivant l'une des revendications précédentes,
comprenant un premier élément (56) de signal affecté au premier départ (28) de courant et respectivement un autre élément (56) de signal affecté à l'autre ou à chaque autre départ (28) de courant,
dans lequel, au moyen du premier élément (56) de signal ou du ou de chaque autre élément (56) de signal, une situation de surcharge dans le départ (28) de courant respectif peut être indiquée.

6. Elément (20) de dérivation suivant l'une des revendications précédentes,
dans lequel, dans le cas d'une situation de surcharge dans l'un des départs (28) de courant, il peut être créé, au moyen du dispositif (40) de contrôle, un signal codant le départ (28) respectif de courant et pouvant être transmis par un bus de champ.

7. Procédé de contrôle automatique d'un premier départ (28) de courant ainsi que d'au moins un autre départ (28) de courant en connexion avec un élément (20) de dérivation, comprenant un élément (30) de circuit connectable électriquement dans un réseau (10) de courant,
dans lequel l'élément (20) de dérivation a une arrivée (26) de courant,
dans lequel, au premier départ (28) de courant, est affecté un premier dispositif (46) de mesure du courant et à l'autre ou à chaque autre départ (28) de courant, est affecté respectivement un autre dispositif (46) de mesure du courant,
dans lequel, au moyen du premier dispositif (46) de mesure du courant ainsi que de l'autre ou de chaque autre dispositif (46) de mesure du courant, on détecte respectivement une valeur (44) de mesure du courant,
dans lequel on compare une somme des valeurs (44) détectées de mesure du courant à une valeur (50) de seuil donnée à l'avance ou pouvant l'être et, en fonction du résultat de la comparaison, on commande l'élément (30) de circuit connectable électriquement de l'élément (20) de dérivation,
**caractérisé en ce que**
l'on compare chaque valeur (44) individuelle détectée de mesure du courant ou une valeur effective ou I²t, qui s'en déduit, à une valeur (52) limite donnée à l'avance ou pouvant l'être et, en fonction du résultat de chaque comparaison, on commande l'élément (30) de circuit connectable électriquement de l'élément (20) de dérivation.

8. Procédé suivant la revendication 7,
dans lequel, pour le premier départ (28) de courant et le ou chaque autre départ (28) de courant, une valeur (52) limite propre est donnée à l'avance respectivement ou peut l'être.

9. Procédé suivant la revendication 7 ou 8,
dans lequel on interconnecte du côté de la sortie au moins deux départs (28) de courant de l'élément (20) de dérivation, et
dans lequel on compare une somme des valeurs (44) détectées de mesure du courant des départs (28) interconnectés de courant à une valeur (52) limite donnée à l'avance ou pouvant l'être et, en fonction du résultat de chaque comparaison, on commande l'élément (30) de circuit connectable électriquement de l'élément (20) de dérivation.

10. Procédé suivant la revendication 7, 8 ou 9,
comprenant un premier élément (56) de signal affecté au premier départ (28) de courant et respectivement un autre élément (56) de signal affecté à l'autre ou à chaque autre départ (28) de courant,
dans lequel, au moyen du premier élément (56) de signal ou de l'autre ou de chaque autre élément (56) de signal, on indique une situation de surcharge dans le départ (28) respectif de courant.

11. Procédé suivant la revendication 7, 8, 9 ou 10,
dans lequel, dans le cas d'une situation de surcharge dans l'un des départs (28) de courant, le dispositif (40) de contrôle crée un signal codant le départ (28) respectif de courant et le transmet par un bus de champ à un récepteur à distance.
